Europäisches Patentamt

European Patent Office

Office européen des brevets

(11) Publication number: **0 179 978**
**B1**

(12) **EUROPEAN PATENT SPECIFICATION**

(45) Date of publication of patent specification: **28.02.90**

(51) Int. Cl.⁵: **H 01 L 41/08**

(21) Application number: **85106590.4**

(22) Date of filing: **29.05.85**

(54) Stacked type piezo-electric device and method of its use.

(30) Priority: **01.11.84 JP 229016/84**

(43) Date of publication of application:
**07.05.86 Bulletin 86/19**

(45) Publication of the grant of the patent:
**28.02.90 Bulletin 90/09**

(84) Designated Contracting States:
**DE FR GB**

(56) References cited:
**DE-A-3 150 696**
**DE-A-3 308 277**
**US-A-4 471 256**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Kobayashi, Noboru**
**211, Sani-haitsu 1-689-1, Mutsukawa**
**Minami-ku Yokohama-shi Kanagawa-ken (JP)**

(74) Representative: **Füchsle, Klaus, Dipl.-Ing. et al**
**Hoffmann . Eitle & Partner Patentanwälte**
**Arabellastrasse 4**
**D-8000 München 81 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a stacked type piezo-electric element device formed by stacking a plurality of piezo-electric elements for transforming electrical energy to mechanical energy, more particularly to a stacked type piezo-electric element device and its method of use.

A stacked type piezo-electric element device in which the piezo-electric elements are stacked in a plurality of stages in order to obtain a high density and large displacement has been known in the past. The device is used in a variety of applications, such as for mechanisms that require a high degree of precision, and functions as an actuator for electrical to mechanical energy conversion.

A known stacked type piezo-electric element device is a parallel type bimorph device in which a plurality of piezo-electric elements sandwiched by the electrodes are stacked, and each of the electrodes is connected in parallel to a power source. A stacked type piezo-electric element is used ordinarily with the thickness of each of the piezo-electric elements chosen as small as possible in order to obtain a large displacement, and with a relatively high voltage applied to the piezo-electric element, because of the fact that the displacement of the piezo-electric element is proportional to the intensity of the electric field. However, this means that dielectric breakdown of the piezo-electric elements themselves or discharge between the electrodes of the piezo-electric elements will be facilitated.

In one prior art stacked type piezo-electric element device of this kind, when, for example, one of the plurality of piezo-electric elements suffers dielectric breakdown, the short-circuit current passes through one power supply line which is connected to one side of the power source, a first voltage impression member which is connected to the power line, an electrode of the piezo-electric element which is connected to the first voltage impression member, and from this electrode, via a piezo-electric element, to the other power line through the other voltage impression member. Because of this, the power source fails to supply a predetermined output voltage, which results in a loss of the displacing function of all of the stacked piezo-electric elements. Namely, even when only a portion of the stacked elements finds itself in a short-circuited state due to dielectric breakdown or the like, it will lead to the problem that the entire function of the stacked type elements as an actuator will be lost.

An object of the present invention is to provide a stacked type piezo-electric element device which remains operational even if dielectric breakdown or the like occurs in a portion of the piezo-electric elements.

Another object of the present invention is to provide a stacked type piezo-electric element device, and a method of its use, which will permit operation as an actuator even in a partially short-circuited state due to dielectric breakdown or the like in a portion of the piezo-electric elements.

According to one aspect of the invention, there is provided a stacked type piezo-electric device (30) for converting electrical energy to mechanical energy, comprising:

a plurality of piezo-electric elements which are stacked, each piezo-electric element having electrodes on respective sides thereof; and

power terminal means comprising at least two terminals for connection to a source of power, one terminal being connected to a first group of said electrodes and the other terminal being connected to a second group of said electrodes, characterised by circuit breaker means arranged to interrupt current through at least one electrode of a said piezo-electric element, in use of the device, if that piezo-electric element breaks down and said current exceeds a predetermined value, such that when said current that exceeds a predetermined value is interrupted, normal currents can continue to be supplied to the remaining electrodes from said power circuit, when connected.

According to a further aspect of the invention, there is provided a method of operating a stacked type piezo-electric device that includes a stack of piezo-electric elements with electrodes on both surfaces, and means for supplying voltage of first and second polarity to respective electrodes of each element, in which method:

the current that flows in at least one of said electrodes is interrupted if it exceeds a predetermined value when one of said piezo-electric elements breaks down and presents a short circuit; and

when said current is interrupted, normal current continues to be supplied to the remaining electrodes, so that the stacked type piezo-electric device continues to operate.

These and other objects, features and advantages of the present invention will be more apparent from the following description of a preferred embodiment, taking in connection with the accompanying drawings, in which:

Figure 1 is an overall perspective view of a prior art stacked type piezo-electric element device;

Figure 2 is a circuit block diagram of the prior art device shown by Figure 1;

Figure 3 is an overall perspective view of a stacked type piezo-electric element device embodying the present invention;

Figures 4a and 4b are perspective views of a printed circuit board of the device shown in Figure 3;

Figure 5 is a cross-sectional view of the electrode section of the device shown in Figure 3;

Figure 6 is a partial cross-sectional perspective view of the coupling section between the printed circuit board and electrodes of the device shown in Figure 3;

Figure 7 is a circuit diagram of the device shown in Figure 3; and

Figure 8 is a circuit diagram for another embodiment of the stacked type piezo-electric element device in accordance with the present invention.

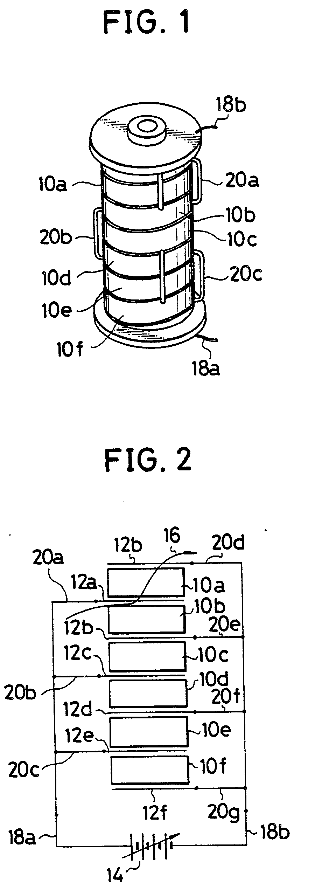

To facilitate understanding of the present invention, a brief reference will be made to a prior art stacked type piezo-electric element device illustrated in Figures 1 and 2.

As shown, a prior art stacked type piezo-electric element device of parallel type bimorph is constructed by stacking a plurality of piezo-electric elements 10a, 10b, 10c, ... by sandwiching them with the electrodes 12a 12b, 12c, ..., and by connecting each of the electrodes 12a, 12b, 12c, ... in parallel to a power source 14. In the above stacked type piezo-electric element device, in order to obtain a large displacement, the thickness of each of the piezo-electric elements 10a, 10b, 10c, ... is ordinarily arranged to have as small a value as is possible, with 10 to 20 of the elements stacked in the practical case, though the case of six elements is illustrated in the Figures. In addition, due to the fact that the displacements of the piezo-electric elements 10a, 10b, 10c, ... are proportional to the intensity of the electric field, the device is frequently used with a relatively high voltage being applied to the piezo-electric elements. However, this means that a dielectric breakdown of the piezo-electric elements themselves or a discharge between the electrodes of the piezo-electric elements will be facilitated.

In such a stacked type piezo-electric element device, when, for example, there occurs a dielectric breakdown in the portion represented by the piezo-electric element 10a, the short-circuit current 16 flows through a power line 18a which is connected to the power source 14, a voltage impression member 20a which is connected to the power 18a, the electrode 12a of the piezo-electric element 10a which is connected to the voltage impression member 20a, and further, from the electrode 12a, via the piezo-electric element 10a, through an electrode 12b, a voltage impression member 20d, to a power line 18b. Therefore, the power source 14 will fail to supply the prescribed output voltage, and hence the displacing function in all of the stacked piezo-electric elements will be lost. That is, the problem occurs that the entire function as an actuator of the stacked type elements is lost even when only a portion of the stacked elements finds itself in a short circuit state due to dielectric breakdown or the like.

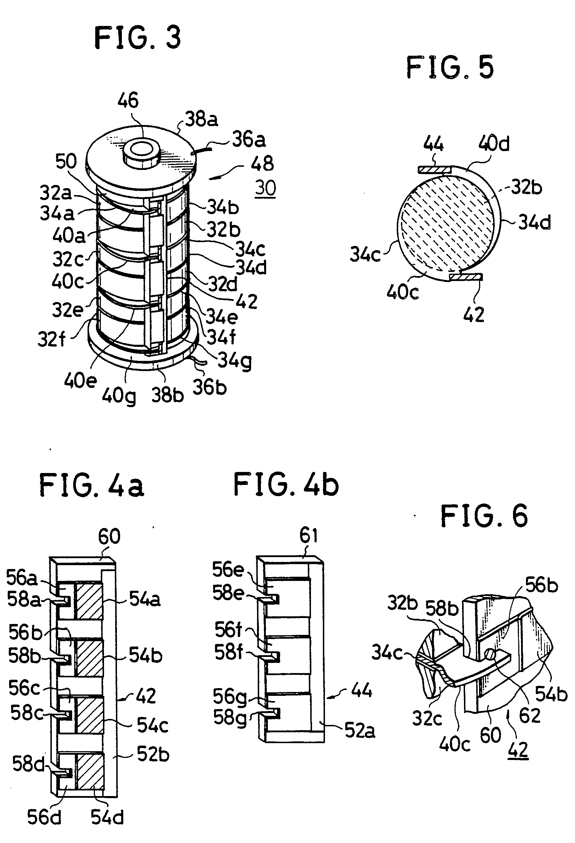

Embodiments of the present invention aimed at solving the problem mentioned in the above will be described by making reference to Figures 3 to 8.

As shown in Figure 3, a stacked type piezo-electric device embodying the present invention is shown with a reference numeral 30. The stacked type piezo-electric device 30 is constructed by stacking a plurality of piezo-electric elements 32a—32f by sandwiching them with electrodes 34a—34g, fixing the entire structure into the form of a tower by means of an adhesive, installing power source terminals 38a and 38b connected to power lines 36a and 36b, on respective ends of the tower structure, and arranging printed circuit boards 42 and 44 (the printed circuit board 44 being arranged on the other side as shown in Figure 5) on sections 40a—40g that protrude as ear sections from the electrodes 34a—34g. Connection of elements of a stacked piezo-electric device by means of a printed circuit board is already known from DE-A-3150 696. The protrusion 46 at the center of each power source terminal 38a and 38b is a mounting screw section for mounting the piezo-electric structure 48 on another part, and there is arranged an insulation member 50 inserted between the rear side of the power source terminal 38a and the electrode 34a.

As shown by Figures 4 to 6, on the printed circuit board 42 there are arranged, in patterned fashion, a conducting section 52b that constitutes the power source line, polysilicon films 54a—54d, and conducting sections 56a—56d that constitute voltage impression members on a piece of glass 60, that has indentations 58a—58d for coupling with the ear sections 40a, 40c, 40e, and 40g of the electrodes 34a, 34c, 34e and 34g, respectively. The polysilicon films 54a—54d are constructed in such a way as to interrupt the circuit current when, for example, an excessive current flows in the piezo-electric element 32a. Such an excessive current flows in the circuit formed by the power line 52a → voltage impression member 56e → piezo-electric element 32a → voltage impression member 56a → circuit breaker 54a → power line 52b → power source, so that the polysilicon film melts down to interrupt the current in this circuit.

Although the circuit breaker in the present embodiment is constructed using an evaporated film of polysilicon, any other kind of melt-down type fuse will do. Thus, for example, it may be a lead fuse. Furthermore, the interrupting function may be incorporated in the piezo-electric element itself, without preparing a circuit breaker externally of the piezo-electric element.

The electrodes 34a-34g are conducting sections extending to form the respective ear sections 40a-40g, the ear sections being arranged to appear on every other layer in order to avoid their overlapping. For example, the ear section 40c of the electrode 34c is positioned so that the ear section 40d is located on the other side of the device. On the ear section 40d which is on the other side, there is installed a further printed circuit board 44 on which are provided a power line 52a and voltage impression members 56e to 56g that apply a voltage to the electrodes 34b, 34d and 34f. The printed circuit board 44 is similar to the board 42 which is installed at the opposing position, but is constructed without the polysilicon films.

The coupling sections of the board 42 (similarly for the printed board 44) and the ear sections 40a, 40c, 40e and 40g of the electrodes 34a, 34c, 34e and 34g, respectively, are soldered at 62 in the indentations 58a—58d, as shown by Figures 4a, 4b and 6 for electrical connection.

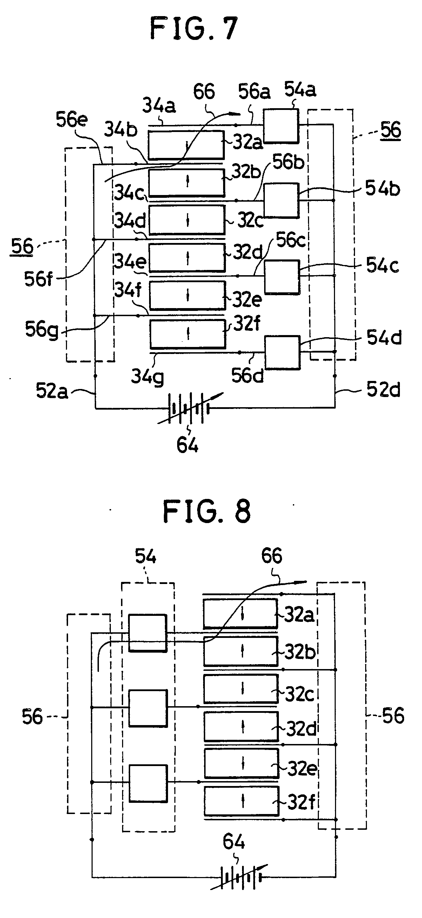

Next, the operation of the stacked type piezo-electric element device constructed in this way will be described by referring to Figure 7.

Figure 7 illustrates the circuit diagram of an example of the stacked type piezo-electric element device which employs the parallel type bimorph. As shown, the electrodes 34a—34g, that are arranged so as to face respective surfaces of the piezo-electric elements 32a—32f are connected respectively to the voltage impression members 56a—56g of a voltage impression section 56, and on the side of the voltage impression members 56a—56d there are inserted circuit breakers 54a-54d between these members and the power line 52b. On the other hand, voltage impression members 56e-56g are connected directly to the power line 52a. Electrical to mechanical conversion of energy by the piezo-electric elements may thus be accomplished by applying the voltage from the power source 64 to the electrode surfaces of the piezo-electric elements 32a—32f.

Suppose now that one of the piezo-electric elements, 32a, say, thus constructed suffers a dielectric breakdown for some reason. Then, the power source 64 will be short-circuited, with an abnormal current 66 flowing in the voltage impression members 56a and 56e. When this abnormal current exceeds a predetermined value, that is, when it is sufficiently strong to fuse the circuit breaker 54a, the voltage impression members 56a and 56e will be interrupted immediately by the melting of the circuit breaker 54a. In other words, no excessive load will be applied to the power source 64 by the interruption of the circuit breaker 54a, protecting the output mechanism of the power source. Not only that, even when the piezo-electric element 32a becomes inoperative, a steady-state voltage will continue to be applied to the remaining piezo-electric elements 32b—32f so that other stacked type elements will continue to maintain the function as an actuator, without ceasing the overall function of the device.

It should be noted in a circuit construction as shown by Figure 7 that an arrangement is made to interrupt the failed element alone by installing the circuit breakers 54 on the side where there are a larger number of voltage impression circuits 56. However, as shown by Figure 8, it is possible to decrease the number of required circuit breakers 54 and make the construction simpler by installing the circuit breakers 54 on the side where there are smaller number of voltage impression circuits 56. In either case, it is possible to minimize the reduction in the function of the device as an actuator.

Various modifications will become possible for those skilled in the art after receiving the teachings of the present disclosure without departing from the scope of the invention as defined by the claims.

## Claims

1. A stacked type piezo-electric device (30) for converting electrical energy to mechanical energy, comprising:
a plurality of piezo-electric elements (32a to 32f) which are stacked, each piezo-electric element having electrodes (34a to 34g) on respective sides thereof; and
power terminal means comprising at least two terminals (38a, 38b) for connection to a source of power (64), one terminal (38a) being connected to a first group (34a, 34c, 34e, 34g) of said electrodes and the other terminal (38b) being connected to a second group (34b, 34d, 34f) of said electrodes, characterised by circuit breaker means (54) arranged to interrupt current through at least one electrode of a said piezo-electric element, in use of the device, if that piezo-electric element breaks down and said current exceeds a predetermined value, such that when said current that exceeds a predetermined value is interrupted, normal currents can continue to be supplied to the remaining electrodes from said power circuit, when connected.

2. A device according to claim 1 wherein each electrode (34a to 34g) is connected to the respective terminal (38a or 38b) via a respective voltage impression member (56a to 56g).

3. A device as claimed in claim 2, in which said circuit breaking means is connected to said voltage impression members (56a to 56g).

4. A device as claimed in claim 3, in which said circuit breaker means comprises circuit breaker elements (54a to 54d) operable to interrupt the current that flows in the voltage impression members.

5. A device as claimed in claim 4, in which each circuit breaker element comprises a melting fuse.

6. A device as claimed in claim 5, in which the melting fuse is made of polysilicon.

7. A device as claimed in any one of claims 4 to 6 in which said circuit breaking means (54) comprise a conductive pattern on insulation boards (60, 61) provided with power supply sections (52a, 52b) and fuse sections (54a—54d) disposed between the supply sections and the voltage impression members (56a—56g).

8. A device as claimed in claim 7, in which the insulation board is a glass member.

9. A device as claimed in any one of the preceding claims in which pairs of said stacked piezo-electric elements form parallel type bimorphs.

10. A device as claimed in claim 9, in which said circuit breaking means is installed on that said of the device which has a larger number of voltage impression members connected to the electrodes of the piezo-electric elements that are arranged in pairs with two surfaces of the same polarity facing each other alternately along the stack.

11. A device as claimed in claim 9, in which said circuit breaking means is installed on that side of the device which has a smaller number of voltage impression members connected to the electrodes of the piezo-electric elements that are arranged in pairs with two surfaces of the same polarity facing each other alternately along the stack.

12. A method of operating a stacked type piezo-electric device that includes a stack of piezo-electric elements with electrodes on both surfaces, and means for supplying voltage of first and second polarity to respective electrodes of each element, in which method:

the current that flows in at least one of said electrodes is interrupted if it exceeds a predetermined value when one of said piezo-electric elements breaks down and presents a short circuit; and

when said current is interrupted, normal current continues to be supplied to the remaining electrodes, so that the stacked type piezo-electric device continues to operate.

**Patentansprüche**

1. Piezo-elektrische Vorrichtung (30) des aufgestapelten Typs zur Umwandlung von elektrischer Energie in mechanische Energie, umfassend

mehrere aufeinandergestapelte piezo-elektrische Elemente (32a bis 32f), die jeweils Elektroden (34a bis 34g) auf entsprechenden Seiten aufweisen, und

eine Energieanschlußeinrichtung mit mindestens zwei Anschlüssen (38a, 38b) zur Verbindung mit einer Energiequelle (64), wobei ein Anschluß (38a) mit einer ersten Gruppe (34a, 34c, 34e, 34g) von Elektroden und der andere Anschluß (38a) mit einer zweiten Gruppe (34b, 34d, 34f) von Elektroden verbunden ist, gekennzeichnet durch eine Stromkreisunterbrechereinrichtung (54), die so angeordnet ist, daß bei Betrieb der Vorrichtung Strom durch wenigstens eine Elektrode des piezo-elektrischen Elementes unterbrochen wird, falls dieses piezo-elektrische Element zusammenbricht und dieser Strom einen vorbestimmten Wert überschrietet, so daß bei Unterbrechung des den vorbestimmten Wert überschreitenden Stromes normale Ströme von der Energiequelle den verbleibenden Elektroden weiterhin zugeführt werden können, wenn sie angeschlossen sind.

2. Vorrichtung nach Anspruch 1, worin jede Elektrode (34a bis 34g) mit dem entsprechenden Anschluß (38a, 38b) über ein entsprechende spannungsführendes Glied (56a bis 56g) verbunden ist.

3. Vorrichtung nach Anspruch 2, worin die Stromkreisunterbrechereinrichtung mit den spannungsführenden Gliedern (56a bis 56g) verbunden ist.

4. Vorrichtung nach Anspruch 3, worin die Stromkreisunterbrechereinrichtung Stromkreisunterbrecherelemente (54a bis 54d) umfaßt, die zum Unterbrechen des in den spannungsführenden Gliedern fließenden Stromes betrieben werden können.

5. Vorrichtung nach Anspruch 4, worin jedes Stromkreisunterbrecherelement eine Schmelzsicherung enthält.

6. Vorrichtung nach Anspruch 5, worin die Schlemzsicherung aus Polysilizium gefertigt ist.

7. Vorrichtung nach einem der Ansprüche 4 bis 6, worin die Stromkreisunterbrechereinrichtung (54) ein leitendes Muster auf Isolationsträgern (60, 61) umfaßt, welche Energiezuführungsbereiche (54a, 54b) und Schmelzbereiche (54a bis 54d) aufweisen, die zwischen den Zuführungsbereichen und den spannungsführenden Gliedern (56a bis 56g) angeordnet sind.

8. Vorrichtung nach Anspruch 7, worin der Isolationsträger ein aus Glas bestehendes Glied darstellt.

9. Vorrichtung nach einem der vorangehenden Ansprüche, worin Paare der gestapelten piezo-elektrischen Elemente Zweifach-Elemente vom Paralleltyp bilden.

10. Vorrichtung nach Anspruch 9, worin die Stromkreisunterbrechereinrichtung auf der Seite der Vorrichtung installiert ist, welche eine größere Anzahl von spannungsführenden Gliedern aufweist, die an die Elektroden der piezo-elektrischen Elemente angeschlossen sind, welche paarweise angeordnet sind mit zwei Flächen der gleichen Polarität, die längs des Stapels abwechselnd einander zugewandt sind.

11. Vorrichtung nach Anspruch 9, worin die Stromkreisunterbrechereinrichtung auf der Seite der Vorrichtung installiert ist, welche eine kleinere Anzahl von spannungsführenden Gliedern aufweist, die an die Elektroden der piezo-elektrischen Elemente angeschlossen sind, welche paarweise angeordnet sind mit zwei Flächen der gleichen Polarität, die längs des Stapels abwechselnd einander zugewandt sind.

12. Verfahren zum Betrieb einer piezo-elektrischen Vorrichtung des aufgestapelten Typs, welche einen Stapel von piezo-elektrischen Elementen mit Elektroden an beiden Flächen sowie eine Einrichtung zum Anlegen einer Spannung einer ersten und zweiten Polarität an entsprechende Elektroden eines jeden Elementes umfaßt, wobei in diesem Verfahren.

der in wenigstens einer der Elektroden fließende Strom unterbrochen wird, falls er einen vorbestimmten Wert übersteigt, wenn eines der piezo-elektrischen Elemente zusammenbricht und einen Kurzschluß herbeiführt, und

bei Unterbrechung dieses Stromes der normale Strom an die verbleibenden Elektroden weiterhin herangeführt wird, so daß die piezo-elektrische Vorrichtung des aufgestapelten Typs in Betrieb bleibt.

**Revendications**

1. Dispositif piézo-électrique du type empilé (30) pour convertir l'énergie électrique en énergie mécanique, comprenant:

une multitude d'éléments piézo-électriques (32a à 32f) qui sont empilés, chaque élément piézo-électrique comportant des électrodes (34a à 34g) sur ces côtés respectifs, et

un moyen de borne d'alimentation comprenant au moins deux bornes (38a, 38b) pour connexion à une source d'énergie (64), une borne (38a) étant connectée à un premier groupe (34a, 34c, 34e, 34g) des électrodes et l'autre borne (38b) étant connectée à un second groupe (34b, 34d, 34f) des électrodes, caractérisé par un moyen de disjoncteur (54) disposé pour interrompre le courant à travers au moins une électrode d'un élément piézo-électrique, lors de l'utilisation du dispositif, si cet élément piézo-électrique est défaillant et si le courant dépasse une valeur prédéterminée, de telle façon que lorsque le courant qui dépasse une valeur prédéterminée est interrompu, des courants normaux peuvent continuer à être fournis aux électrodes restantes en provenance dudit circuit d'alimentation, lorsqu'il est connecté.

2. Dispositif selon la revendication 1, dans lequel chaque électrode (34a à 34g) est connectée à la borne respective (38a ou 38b) via un élément d'application de tension respectif (56a à 56g).

3. Dispositif selon la revendication 2, dans lequel le moyen de disjoncteur est connecté aux éléments d'application de tension (56a à 56g).

4. Dispositif selon la revendication 3, dans lequel le moyen de disjoncteur comprend des éléments de disjoncteurs (54a à 54d) pouvant être commandés pour interrompre le courant qui circule dans les éléments d'application de tension.

5. Dispositif selon la revendication 4, dans lequel chaque élément de disjoncteur comprend un fusible à fusion.

6. Dispositif selon la revendication 5, dans lequel le fusible à fusion est constitué de polysilicium.

7. Dispositif selon l'une quelconque des revendications 4 à 6, dans lequel le moyen de disjoncteur (54) comprend un dessin conducteur sur des cartes d'isolation (60, 61) pourvues de sections d'alimentation de puissance (52a, 52b) et des sections de fusible (54a à 54) disposées entre les sections d'alimentation et les éléments d'application de tension (56a à 56g).

8. Dispositif selon la revendication 7, dans lequel la carte d'isolation est un élément de verre.

9. Dispositif selon l'une quelconque des revendications précédentes dans lequel des paires des éléments piézo-électriques empilés forment des bimorphes du type parallèle.

10. Dispositif selon la revendication 9, dans lequel le moyen de disjoncteur est installé sur celui du dispositif qui a le nombre le plus important d'éléments d'application de tension connectés aux électrodes des éléments piézo-électriques qui sont disposées en paires avec deux surfaces de même polarité étant opposées l'une à l'autre alternativement le long de la pile.

11. Dispositif selon la revendication 9, dans lequel le moyen de disjoncteur est installé sur le côte du dispositif qui comporte le nombre le plus petit d'éléments d'application de tension connectés aux électrodes des éléments piézo-électriques qui sont disposées en paires avec deux surfaces de même polarité se faisant face l'une à l'autre de manière alternée le long de la pile.

12. Procédé de commande d'un dispositif piézo-électrique du type empilé qui comprend une pile d'éléments piézo-électriques avec des électrodes sur chaque surface, et un moyen pour fournir une tension d'une première et d'une seconde polarités aux électrodes respectives de chaque élément, dans lequel procédé:

le courant qui circule dans au moins une électrode des électrodes est interrompu s'il dépasse une valeur prédéterminé lorsqu'un élément des éléments piézo-électriques et défaillant et présente un court-circuit, et

lorsque le courant est interrompu, un courant normal continue à être fourni aux électrodes restantes de façon que le dispositif piézo-électrique continue à fonctionner.

# FIG. 1

# FIG. 2

## FIG. 3

## FIG. 5

## FIG. 4a

## FIG. 4b

## FIG. 6

# FIG. 7

# FIG. 8